# EUROPEAN PATENT APPLICATION

(11) **EP 4 847 892 A1**
(43) Date of publication of application: **02.12.2026**
(21) Application number: 26187607.2
(22) Date of filing: 25.06.2026
(51) Int. Cl.: G01J 5/00

(54) **BODY TEMPERATURE MEASURING APPARATUS AND CONTROL METHOD**

(30) Priority: 30.06.2025 CN 202510902053
(71) Applicant: Shenzhen Lute Jiacheng Supply Chain Management Co., Ltd., Shenzhen, Guangdong 518000 (CN)
(72) Inventor: JIA, Caihu, Shenzhen, Guangdong, 518000 (CN); WANG, Jun, Shenzhen, Guangdong, 518000 (CN); YIN, Hao, Shenzhen, Guangdong, 518000 (CN); OUYANG, Xue, Shenzhen, Guangdong, 518000 (CN)
(74) Representative: Winter, Brandl - Partnerschaft mbB

(57) **Abstract**

A body temperature measuring apparatus includes a main unit, a main cover, a detecting assembly, and a control assembly. The main unit includes a forehead temperature probe and an ear temperature probe. The ear temperature probe has an extending portion for inserting into an ear canal. The main cover has a preset state where it covers the two probs, and a non-preset state where it is detached from the main unit. The detecting assembly is arranged on the main unit and/or the main cover, and is used for detecting whether the main cover is in the preset state. The control assembly is electrically connected to the detecting assembly and the two probs. The control assembly obtains whether the main cover is in the preset state through the detecting assembly, to select to turn on both the probs or only turn on the ear temperature probe.

## Description

### CROSS-REFERENCE TO RELATED APPLICATIONS

The present application claims priority of Chinese Patent Application No. 202510902053.0, filed on June 30, 2026, the entire contents of which are hereby incorporated by reference.

### TECHNICAL FIELD

The present disclosure relates to body temperature measurement, in particular to a body temperature measuring apparatus and a control method thereof.

### BACKGROUND

An CN212585836U patent application discloses an infrared thermometer, which includes a forehead temperature probe and an ear temperature probe. The forehead temperature probe is installed on a main shell, and the ear temperature probe is detachably sleeved on the forehead temperature probe. When the ear temperature probe is removed, an extending portion of the forehead temperature probe can extend into the ear canal to measure the ear temperature; when the ear temperature probe is sleeved on the forehead temperature probe, the ear temperature probe can be close to the forehead for temperature measurement. Under such arrangement, when the forehead temperature is needed, the user has to manually sleeve the ear temperature probe on the forehead temperature probe; when measuring the ear temperature, the user needs to remove the ear temperature probe. Frequent installation and disassembly of the ear temperature probe will affect the stability of the electrical connection part of the ear temperature probe. In the forehead temperature measurement mode, only the ear temperature probe is used for temperature measurement, resulting in low temperature measurement accuracy.

### SUMMARY

The present disclosure provides a body temperature measuring apparatus and a control method thereof, aiming to solve the problem that the forehead temperature probe in a dual-probe body temperature measuring apparatus needs frequent disassembly, which affects its use stability, and at the same time improve the temperature measurement accuracy of the body temperature measuring apparatus.

On one hand, the present disclosure provides a body temperature measuring apparatus, which includes a main unit, a main cover, a detecting assembly, and a control assembly. The main unit includes a forehead temperature probe and an ear temperature probe, and the ear temperature probe includes an extending portion for inserting into an ear canal. The main cover is provided with a preset state where the main cover is connected to the main unit and covers the forehead temperature probe and the ear temperature probe, and a non-preset state where the main cover is detached from the main unit. The main cover defines a first channel and a second channel for temperature measurement signals to pass through, the forehead temperature probe faces the first channel or partially extends into the first channel in the preset state, and the extending portion partially extends into the second channel in the preset state. The detecting assembly is arranged on the main unit and/or the main cover and is used for detecting whether the main cover is in the preset state. The control assembly is electrically connected to the detecting assembly, the forehead temperature probe, and the ear temperature probe. The control assembly obtains whether the main cover is in the preset state through the detecting assembly, and selects to turn on both the forehead temperature probe and the ear temperature probe or only turn on the ear temperature probe.

In one embodiment, the detecting assembly is arranged at a coupling position of the main unit and the main cover.

In one embodiment, the detecting assembly includes a magnetic member and a Hall sensing element that generates a magnetic induction signal when the magnetic member is close. The Hall sensing element is arranged at the coupling position of the main unit that couples with the main cover, the magnetic member is arranged at the coupling position of the main cover that couples with the main unit, the control assembly is electrically connected to the Hall sensing element, and the control assembly selects to turn on both the forehead temperature probe and the ear temperature probe or only turn on the ear temperature probe according to whether the Hall sensing element generates the magnetic induction signal. And/or, the detecting assembly includes a pressure sensor triggered by the main cover in the preset state, the pressure sensor is arranged at the coupling position of the main unit with the main cover. The control assembly is electrically connected to the pressure sensor, and the control assembly selects to turn on both the forehead temperature probe and the ear temperature probe or only turn on the ear temperature probe according to whether the pressure sensor senses a pressure signal.

In one embodiment, the main cover includes an outer shell, a first cover plate, a second cover plate, a first inner shell, and a second inner shell. The outer shell includes a first opening facing the main unit and a second opening deviating from the main unit, the first cover plate covers the first opening, and the second cover plate covers the second opening. The first cover plate and the second cover plate respectively define a first avoiding opening, the two first avoiding openings are arranged oppositely; the first inner shell is arranged between the first cover plate and the second cover plate to surround the two first avoiding openings; the first inner shell defines the first channel. The first cover plate and the second cover plate respectively define a second avoiding opening, the two second avoiding openings are arranged oppositely, the second inner shell is arranged between the first cover plate and the second cover plate to surround the two second avoiding opening, the second inner shell defines the second channel.

In one embodiment, the ear temperature probe further includes a fixing portion and a first temperature sensing element. The fixing portion is connected to an end of the main unit facing the main cover, the extending portion protrudes from the fixing portion towards the main cover. The extending portion defines an accommodating cavity extending along an axial direction thereof, one end of the extending portion far away from the fixing portion is provided with an emission port communicated with the accommodating cavity, and the first temperature sensing element is arranged in the accommodating cavity. The forehead temperature probe includes a second temperature sensing element, the second temperature sensing element is arranged on a side of the fixing portion facing the main cover and is arranged corresponding to the second channel. Or, the second temperature sensing element is arranged on a side of the fixing portion deviating from the main cover and is arranged corresponding to the second channel, and the fixing portion defines an avoiding hole arranged corresponding to the second temperature sensing element.

In one embodiment, the body temperature measuring apparatus further includes a distance sensor arranged at an end of the main unit facing the main cover, the control assembly is electrically connected to the distance sensor and controls the distance sensor to be turned on or off according to the signal fed back by the detecting assembly. The main cover defines a third channel, and the distance sensor faces the third channel or at least partially extends into the third channel.

In one embodiment, the main cover includes an outer shell, a first cover plate, a second cover plate, and a third inner shell. The outer shell includes a first opening facing the main unit and a second opening deviating from the main unit, the first cover plate covers the first opening, and the second cover plate covers the second opening. The first cover plate and the second cover plate respectively define a third avoiding opening, the two third avoiding openings are arranged oppositely, the third inner shell is arranged between the first cover plate and the second cover plate to surround the third avoiding opening, and the third inner shell defines the third channel.

On another hand, the present disclosure also provides a control method for controlling the body temperature measuring apparatus, the control method includes:
detecting whether a main cover is in a preset state or a non-preset state through a detecting assembly, wherein the preset state is a state where the main cover is connected to a main unit and covers a forehead temperature probe and a ear temperature probe, and the non-preset state is a state where the main cover is detached from the main unit;
when the main cover is in the preset state, turning on both the forehead temperature probe and the ear temperature probe, and fitting a temperature value obtained by the forehead temperature probe and another temperature value obtained by the ear temperature probe to obtain an output temperature value;
when the main cover is in the non-preset state, turning off the forehead temperature probe and turning on the ear temperature probe, and taking a temperature value obtained by the ear temperature probe as an output temperature value.

In one embodiment, the body temperature measuring apparatus comprises a distance sensor and a distance prompting device, the distance sensor is arranged at an end of the main unit facing the main cover, and the distance prompting device is arranged on the main unit and is electrically connected to the distance sensor;
when the main cover is in the preset state, after turning on both the forehead temperature probe and the ear temperature probe, the method further comprises;
detecting whether a distance between the distance sensor and a site to be measured is within a preset distance range;
when the distance between the distance sensor and the site to be measured is within the preset distance range, obtaining temperature values detected respectively by the forehead temperature probe and the ear temperature probe, and fitting a temperature value obtained by the forehead temperature probe and another temperature value obtained by the ear temperature probe to obtain an output temperature value;
when the distance between the distance sensor and the site to be measured is outside the preset distance range, controlling the distance prompting device to send out prompting information;
when the main cover is in the non-preset state, turning of the distance sensor and the distance prompting device.

In one embodiment, when the main cover is in the preset state, the method further comprises the following steps:
judging whether a difference between a first temperature value currently obtained by the forehead temperature probe and a second temperature value currently obtained by the ear temperature probe is within a preset temperature difference;
when the difference between the first temperature value and the second temperature value is within the preset temperature difference, fitting the first temperature value and the second temperature value to obtain an output temperature value;
when the difference between the first temperature value and the second temperature value is outside the preset temperature difference, controlling the forehead temperature probe and the ear temperature probe to measure the temperature again.

In one embodiment, when the difference between the first temperature value and the second temperature value is within the preset temperature difference, a formula for fitting the first temperature value and the second temperature value is *T* = *(T*1 + *T*2)/2,where T is the output temperature value, T1 is the first temperature value, and T2 is the second temperature value.

In one embodiment, after controlling the forehead temperature probe and the ear temperature probe to measure the temperature again, the method further comprises the following steps:
judging whether a difference between a third temperature value obtained again by the forehead temperature probe and a fourth temperature value obtained again by the ear temperature probe is within the preset temperature difference;
when the difference between the third temperature value and the fourth temperature value is within the preset temperature difference, fitting the third temperature value and the fourth temperature value to obtain an output temperature value;
when the difference between the third temperature value and the fourth temperature value is outside the preset temperature difference, fitting the first to fourth temperature values to obtain an output temperature value.

In one embodiment, when the difference between the third temperature value and the fourth temperature value is within the preset temperature difference, a formula for fitting the third temperature value and the fourth temperature value is *T* = (*T*3 + *T*4)/2, where T is the output temperature value, T3 is the third temperature value, and T4 is the fourth temperature value.

In one embodiment, when the difference between the third temperature value and the fourth temperature value is outside the preset temperature difference, a formula for fitting the first to fourth temperature values is *T = (T1 + T2* + *T3* + *T*4)/4, where T is the output temperature value, T1 is the first temperature value, T2 is the second temperature value, T3 is the third temperature value, and T4 is the fourth temperature value; or
a formula for fitting the first to fourth temperature values is *T =* ((*w*1 *•* (*T*1 *+* T3)/2) + (*w2* • (*T2* + *T*4)/2))/(*w*1 + *w*2), where T is the output temperature value, T1 is the first temperature value, T2 is the second temperature value, T3 is the third temperature value, T4 is the fourth temperature value, w1is a weight of the average value of the first temperature value and the third temperature value, w2is a weight of the average value of the second temperature value and the fourth temperature value; when |*T*1 - *T*3| *=* |*T*2 - *T*4|*,* then w1 *= w*2*,* when |*T*1 *- T*3| < |*T*2 - *T*4|*,* then w1 *> w*2*,* when |*T*1 *- T*3| *>* |*T*2 - *T*2|*,* then w1 < *w*2*.*

In the body temperature measuring apparatus provided by the present disclosure, the ear temperature probe has an extending portion for inserting into the ear canal. When the main cover is removed, the extending portion of the ear temperature probe can be inserted into the ear canal for ear temperature measurement. The body temperature measuring apparatus has an ear temperature measurement mode and a forehead temperature measurement mode. When the main cover is removed from the main unit, that is, when the control assembly detects that the main cover is in the non-preset state, the body temperature measuring apparatus is in the ear temperature measurement mode. Then, the control assembly turns on the ear temperature probe, turns off the forehead temperature probe, and only the ear temperature probe is working. When the main unit is attached to the main unit and covers the ear temperature probe and the forehead temperature probe, that is, when the control assembly detects that the main cover is in the preset state, the body temperature measuring apparatus is in the forehead temperature measurement mode. Then, the control assembly turns on both the ear temperature probe and the forehead temperature probe, and both the ear temperature probe and the forehead temperature probe are in the working state, which are jointly used for forehead temperature measurement. In the technical solution, both the ear temperature probe and the forehead temperature probe are arranged on the main unit, and the automatic switching of the temperature measurement mode is realized by detecting whether the main cover covers the main unit through the detecting assembly.

Since the main function of the main cover is to protect the probes and realize the switching of the temperature measurement mode, rather than directly participating in temperature measurement, the disassembly and installation of the main cover will not affect the stability of the electrical connection part of the temperature measurement probes. Even if the connection part of the main cover is slightly worn, it will not affect the temperature measurement function of the temperature measurement probes, thus ensuring the service life of the first temperature measurement probe and the second temperature measurement probe.

Moreover, in the technical solution, the disassembly operation of the main cover will not affect the electrical connection between the ear temperature probe, the forehead temperature probe and the control assembly, which means that in the forehead temperature measurement mode, the ear temperature probe and the forehead temperature probe can measure the temperature at the same time, and the control assembly can obtain the temperature measurement data of the ear temperature probe and the forehead temperature probe at the same time. Since the dual probes can cover more areas, for example, the ear temperature probe may be located at the center of the forehead, and the forehead temperature probe may be located around the center of the forehead, the error caused by the local temperature change of a single measurement point can be reduced. Through the algorithm processing of the control assembly, a value more in line with the real human body temperature can be obtained, and the temperature measurement accuracy can be improved.

### BRIEF DESCRIPTION OF DRAWINGS

In order to illustrate the technical solutions more clearly in the embodiments of the present disclosure, the drawings needed in the embodiments will be briefly introduced below. Obviously, the drawings in the following description are only some embodiments of the present disclosure. For those of ordinary skill in the art, other drawings can be obtained according to these drawings without creative work.
FIG. 1 is an exploded view of a main unit and a main cover of an embodiment of the body temperature measuring apparatus provided by the present disclosure;
FIG. 2 is a schematic view of an embodiment of the body temperature measuring apparatus provided by the present disclosure after assembly;
FIG. 3 is a schematic view of FIG. 2 from another perspective;
FIG. 4 is an exploded view of a main cover in an embodiment of the body temperature measuring apparatus provided by the present disclosure;
FIG. 5 is a schematic view of the main cover in an embodiment of the body temperature measuring apparatus provided by the present disclosure after removing the outer shell;
FIG. 6 is a schematic structural view of an ear temperature probe in an embodiment of the body temperature measuring apparatus provided by the present disclosure;
FIG. 7 is a cross-sectional view of an ear temperature probe and a main cover in an embodiment of the body temperature measuring apparatus provided by the present disclosure after assembly;
FIG. 8 is a flow chart of an embodiment of the control method provided by the present disclosure;
FIG. 9 is a flow chart of another embodiment of the control method provided by the present disclosure;
FIG. 10 is a block diagram showing the electrical connection between parts of the elements of the body temperature measuring apparatus provided by the present disclosure.

### Reference numerals:

100. Body temperature measuring apparatus; 1. Main unit; 11. Ear temperature probe; 111. Fixing portion; 1111. Avoiding hole; 1112. Step portion; 112. Extending portion; 113. First temperature sensing element; 12. Forehead temperature probe; 13. Distance sensor; 2. Main cover; 21. Outer shell; 22. First cover plate; 23. Second cover plate; 24. First avoiding opening; 25. Second avoiding opening; 26. Third avoiding opening; 27. First inner shell; 28. Second inner shell; 29. Third inner shell; 30. First channel; 31. Second channel; 32. Third channel; 41. Temperature unit switching button; 42. Control button; 5. Screen; 6. detecting assembly; 7. control assembly; 1a/2a. coupling position.

### DESCRIPTION OF EMBODIMENTS

In order to make the purpose, technical solutions and advantages of the present disclosure clearer, the present disclosure will be further described in detail below with reference to the accompanying drawings and embodiments. It should be understood that the specific embodiments described here are only used to explain the present disclosure, and are not used to limit the present disclosure.

It should be noted that the terms "arranged" and "connected" should be understood in a broad sense, for example, they can be directly arranged and connected, or indirectly arranged and connected through intermediate components and intermediate structures.

In addition, in the embodiments of the present disclosure, if there are terms such as "longitudinal", "transverse", "length", "width", "thickness", "upper", "lower", "front", "rear", "left", "right", "vertical", "horizontal", "top", "bottom", "inner" and "outer" indicating orientation or positional relationship, they are based on the orientation or positional relationship shown in the drawings or the conventional placement state or use state, which are only for the convenience of describing the present disclosure and simplifying the description, rather than indicating or implying that the structure, feature, apparatus or element referred to must have a specific orientation or positional relationship, or must be constructed and operated in a specific orientation, so they cannot be understood as limiting the present disclosure. In the description of the present disclosure, unless otherwise specified, "plurality" means two or more.

In the specific implementation, the various specific technical features and various embodiments described can be combined in any appropriate way. For example, different specific technical features/embodiments can be combined to form different implementations. In order to avoid unnecessary repetition, the various possible combinations of the various specific technical features/embodiments in the present disclosure will not be described separately.

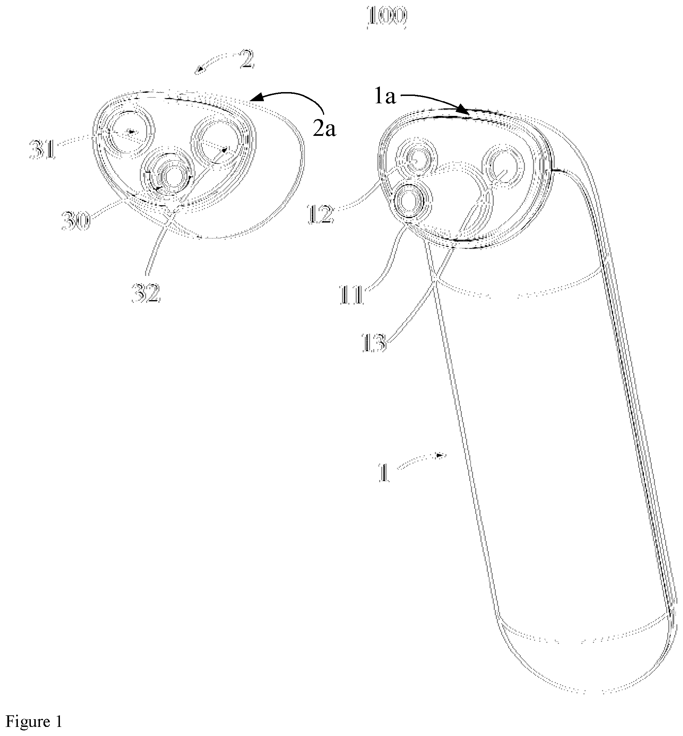

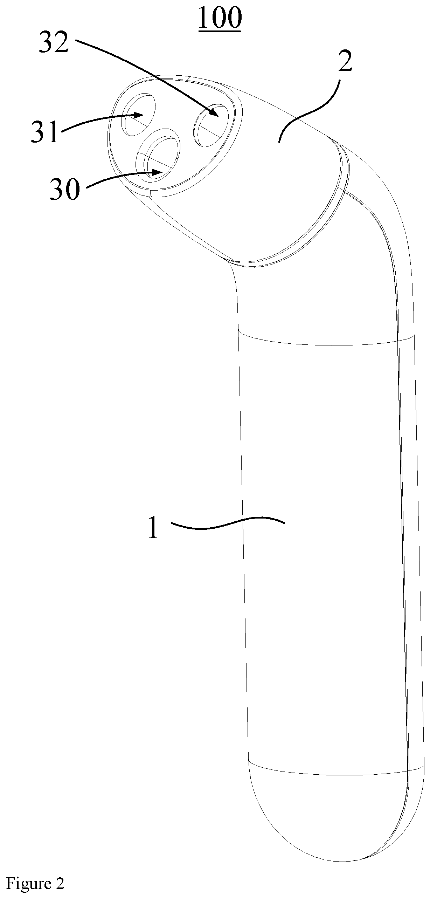

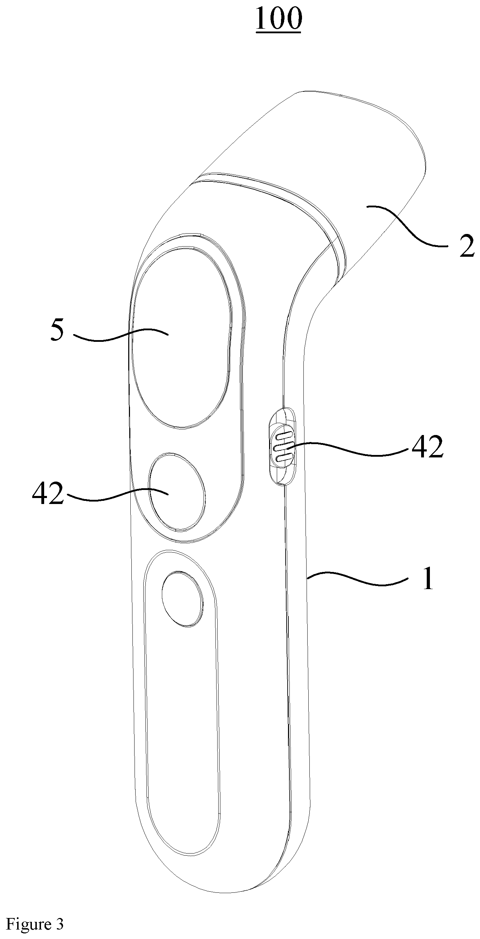

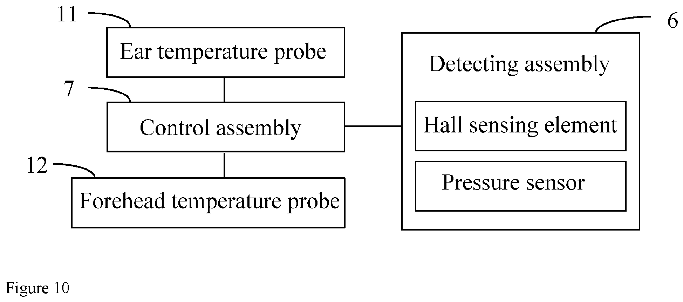

Referring to FIGS. 1-3 and FIG. 10, the body temperature measuring apparatus 100 provided by the present disclosure includes a main unit 1, a main cover 2, a detecting assembly 6 and a control assembly 7. The main unit 1 is provided with a forehead temperature probe 12 and an ear temperature probe 11. The ear temperature probe 11 has an extending portion 112 for inserting into an ear canal. The main cover 2 has a preset state where it is connected to the main unit 1 and covers the forehead temperature probe 12 and the ear temperature probe 11, and a non-preset state where it is detached from the main unit 1. The main cover 2 is provided with a first channel 30 and a second channel 31 for temperature measurement signals to pass through. The forehead temperature probe 12 faces the first channel 30 or at least partially extends into the first channel 30 in the preset state, and the extending portion 112 partially extends into the second channel 31 in the preset state. The detecting assembly 6 is arranged on the main nuit 1 and/or the main cover 2, and is used for detecting whether the main cover 2 is in the preset state. In the present embodiment, it takes the detecting assembly 6 being arranged at a coupling position of the main unit 1 and the main cover 2 as an example, for example the coupling position 1a, 2a shown in FIG. 1; however it should be understood that other position may be available as long as the detecting assembly 6 is capable of detecting whether the main cover 2 is in the preset state. The control assembly 7 is electrically connected to the detecting assembly 6, the forehead temperature probe 12 and the ear temperature probe 11. The control assembly 7 obtains whether the main cover 2 is in the preset state through the detecting assembly 6, so as to select to turn on both the forehead temperature probe 12 and the ear temperature probe 11 or only turn on the ear temperature probe 11.

In the body temperature measuring apparatus 100 provided by the present disclosure, the ear temperature probe 11 has an extending portion 112 for inserting into the ear canal. When the main cover 2 is removed, the extending portion 112 of the ear temperature probe 11 can be inserted into the ear canal for ear temperature measurement. The body temperature measuring apparatus 100 has an ear temperature measurement mode and a forehead temperature measurement mode. When the main cover 2 is removed from the main unit 1, that is, when the control assembly 7 detects that the main cover 2 is in the non-preset state, the body temperature measuring apparatus 100 is in the ear temperature measurement mode. Then, the control assembly 7 turns on the ear temperature probe 11, turns off the forehead temperature probe 12, and only the ear temperature probe 11 is in the working state. When the main cover 2 is connected to the main unit 1 and covers the ear temperature probe 11 and the forehead temperature probe 12, that is, when the control assembly 7 detects that the main cover 2 is in the preset state, the body temperature measuring apparatus 100 is in the forehead temperature measurement mode. Then, the control assembly 7 turns on both the ear temperature probe 11 and the forehead temperature probe 12, and both the ear temperature probe 11 and the forehead temperature probe 12 are in the working state, which are jointly used for forehead temperature measurement. In the technical solution, both the ear temperature probe 11 and the forehead temperature probe 12 are arranged on the main unit 1, and the automatic switching of the temperature measurement mode is realized by detecting whether the main cover 2 covers the main unit 1 through the detecting assembly 6. Since the main function of the main cover 2 is to protect the probes and realize the switching of the temperature measurement mode, rather than directly participating in temperature measurement, the disassembly and installation of the main cover 2 will not affect the stability of the electrical connection part of the temperature measurement probes. Even if the connection part of the main cover 2 is slightly worn, it will not affect the temperature measurement function of the temperature measurement probes, thus ensuring the service life of the first temperature measurement probe and the second temperature measurement probe. Moreover, in the technical solution, the disassembly operation of the main cover 2 will not affect the electrical connection between the ear temperature probe 11, the forehead temperature probe 12 and the control assembly 7, which means that in the forehead temperature measurement mode, the ear temperature probe 11 and the forehead temperature probe 12 can measure the temperature at the same time, and the control assembly 7 can obtain the temperature measurement data of the ear temperature probe 11 and the forehead temperature probe 12 at the same time. Since the dual probes can cover more areas, for example, the ear temperature probe 11 may be located at the center of the forehead, and the forehead temperature probe 12 may be located around the center of the forehead, the error caused by the local temperature change of a single measurement point can be reduced. Through the algorithm processing of the control assembly 7, a value more in line with the real human body temperature can be obtained, and the temperature measurement accuracy can be improved.

The main cover 2 and the main unit 1 can be connected by magnetic attraction. Specifically, the main cover 2 can be provided with a first magnetic attraction part, and the main unit 1 can be provided with a second magnetic attraction part. The main cover 2 and the main unit 1 are attached by the attraction of the first magnetic attraction part and the second magnetic attraction part. The magnetic attraction connection has the characteristic of automatic alignment. When the main cover 2 is close to the main unit 1, the magnetic force will naturally guide the connection part of the main cover 2 and the main unit 1 to align automatically, so as to realize the quick installation of the main cover 2. In addition, the user can easily remove the main cover 2 from the main unit 1 by gently pulling, and the disassembly process is also simple and fast. Alternatively, the main cover 2 and the main unit 1 can be connected by a buckle. Specifically, the main cover 2 and the main unit 1 are connected by the mutual buckling of the buckle structure. The buckle connection has high firmness and stability, and this connection mode can effectively prevent the main cover 2 from being accidentally loosened or falling off due to external forces during use.

In the technical solution, the detecting assembly 6 can include a magnetic member and a Hall sensing element that generates a magnetic induction signal when the magnetic member is close. The Hall sensing element is arranged at the coupling position 1a of the main unit 1 that couples with the main cover 2, and the magnetic member is arranged at the coupling position 2a of the main cover 2 that couples with the main unit 1. The control assembly 7 is electrically connected to the Hall sensing element, and the control assembly 7 selects to turn on both the forehead temperature probe 12 and the ear temperature probe 11 or only turn on the ear temperature probe 11 according to whether the Hall sensing element generates the magnetic induction signal.

The Hall sensing element can be arranged on the surface of the main unit 1 that contacts the main cover 2, and the magnetic member can be arranged on the surface of the main cover 2 that contacts the main unit 1. Alternatively, the Hall sensing element can be arranged inside the main unit 1 and close to the main cover 2, and the magnetic member can be arranged at the end of the main cover 2 close to the main unit 1. The Hall sensing element is a sensor based on the Hall effect, which can output an electrical signal when detecting a change in the magnetic field. When the main cover 2 is connected to the main unit 1, the magnetic member is close to the Hall sensing element, triggering the Hall sensing element to generate a magnetic induction signal; when the main cover 2 is removed, the magnetic field disappears, and the Hall sensing element no longer generates an induction signal.

The control assembly 7 is electrically connected to the Hall sensing element, and the control assembly 7 selectively turns on or off the forehead temperature probe 12 according to whether the Hall sensing element generates a magnetic induction signal, so as to realize the switching between the ear temperature measurement mode and the forehead temperature measurement mode. Specifically, when the Hall sensing element detects a magnetic induction signal (that is, when the main cover 2 is connected to the main unit 1), the control assembly 7 switches to the forehead temperature measurement mode, and at this time, both the ear temperature probe 11 and the forehead temperature probe 12 are in the working state; when the Hall sensing element does not detect a magnetic induction signal (that is, when the main cover 2 is removed), the control assembly 7 switches to the ear temperature measurement mode, and at this time, only the ear temperature probe 11 is in the working state. In this embodiment, the automatic switching of the temperature measurement mode is realized through the cooperation of the magnetic member and the Hall sensing element. The Hall sensing element has the characteristics of high sensitivity and fast response, and can accurately detect the change of the magnetic field, thus ensuring the accuracy and reliability of the switching of the temperature measurement mode.

Alternatively, the detecting assembly 6 can adopt a pressure sensor, which can generate a pressure signal when the main cover 2 is in the preset state. The pressure sensor is arranged at the coupling position 1a of the main unit 1 that couples with the main cover 2, and the control assembly 7 is electrically connected to the pressure sensor. The control assembly 7 selects to turn on both the forehead temperature probe 12 and the ear temperature probe 11 or only turn on the ear temperature probe 11 according to whether the pressure sensor senses a pressure signal.

For example, the main unit 1 has a contact surface in contact with the main cover 2, and the pressure sensor can be arranged on the contact surface to detect the contact pressure between the main cover 2 and the main unit 1, so as to monitor whether the main cover 2 covers the main unit 1. Alternatively, the main cover 2 can be convexly provided with a pressing part. When the main cover 2 covers the main unit 1, the pressing part contacts with and presses the pressure sensor, so as to prompt the pressure sensor to generate a pressure signal. The pressure sensor can output an electrical signal when detecting pressure. When the main cover 2 covers the main unit 1, the pressure sensor will sense the pressure and output a signal; when the main cover 2 is removed, the pressure disappears, and the sensor no longer outputs a signal. The control assembly 7 is electrically connected to the pressure sensor, and selectively turns on or off the forehead temperature probe 12 according to whether the pressure sensor senses a pressure signal, so as to realize the switching between the ear temperature measurement mode and the forehead temperature measurement mode. Specifically, when the pressure sensor detects a pressure signal (that is, when the main cover 2 is connected to the main unit 1), the control assembly 7 switches to the forehead temperature measurement mode, and at this time, both the ear temperature probe 11 and the forehead temperature probe 12 are in the working state; when the pressure sensor does not detect a pressure signal, only the ear temperature probe 11 is in the working state. The pressure sensor has the characteristics of high sensitivity and fast response, and can accurately detect the contact pressure between the main cover 2 and the main unit 1, thus ensuring the accuracy and reliability of the switching of the temperature measurement mode.

In practical application, the pressure sensor, the Hall sensing element and the magnetic member can coexist. In this case, the detecting assembly 6 adopts double detection, which makes the installation state of the main cover 2 more accurate. Even if one of the sensing elements fails or misjudges, the other sensing element can still perform detection, improving the overall reliability of the device.

In the technical solution, the ear temperature probe 11 and the forehead temperature probe 12 can be infrared temperature measurement probes, which mainly measure the temperature by detecting the infrared radiation energy emitted by the surface of the object through their respective infrared sensors. In order to avoid the main cover 2 blocking the infrared light of the ear temperature probe 11 and the forehead temperature probe 12 when covering the ear temperature probe 11 and the forehead temperature probe 12, the main cover 2 is provided with a first channel 30 and a second channel 31 for temperature measurement signals to pass through. The forehead temperature probe 12 faces the first channel 30 or partially extends into the first channel 30 in the preset state, and the extending portion 112 partially extends into the second channel 31 in the preset state.

For example, the main cover 2 can be provided with a first window and a second window at intervals. The first window is arranged opposite to the ear temperature probe 11, and the second window is arranged opposite to the forehead temperature probe 12. The coverage area of the first window is the first channel 30, and the coverage area of the second window is the second channel 31. The first window and the second window can be hole structures, or the first window and the second window can be light-transmitting plates covering the hole structures, such as light-transmitting glass. The first window is used as the infrared receiving point of the ear temperature probe 11, and the second window is used as the infrared receiving point of the forehead temperature probe 12, so that the temperature measurement signals of the ear temperature probe 11 and the forehead temperature probe 12 can be emitted freely.

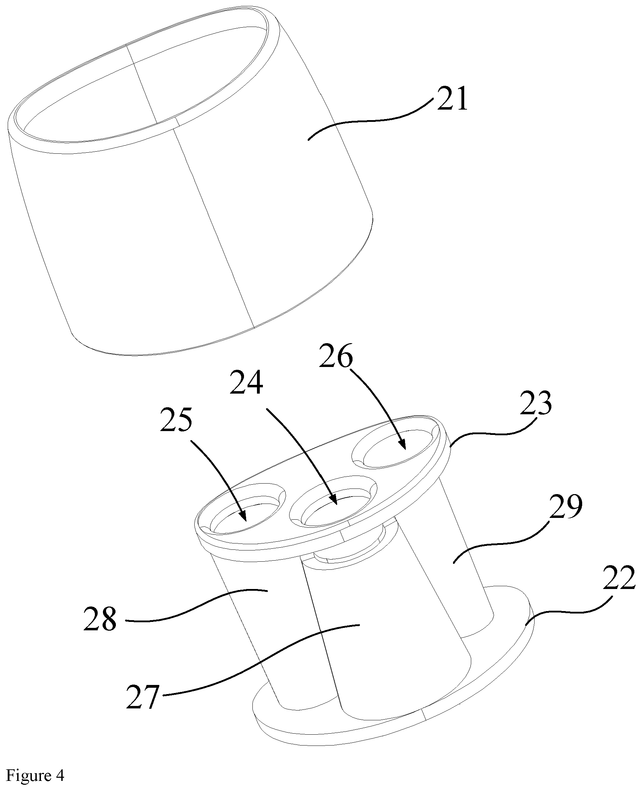

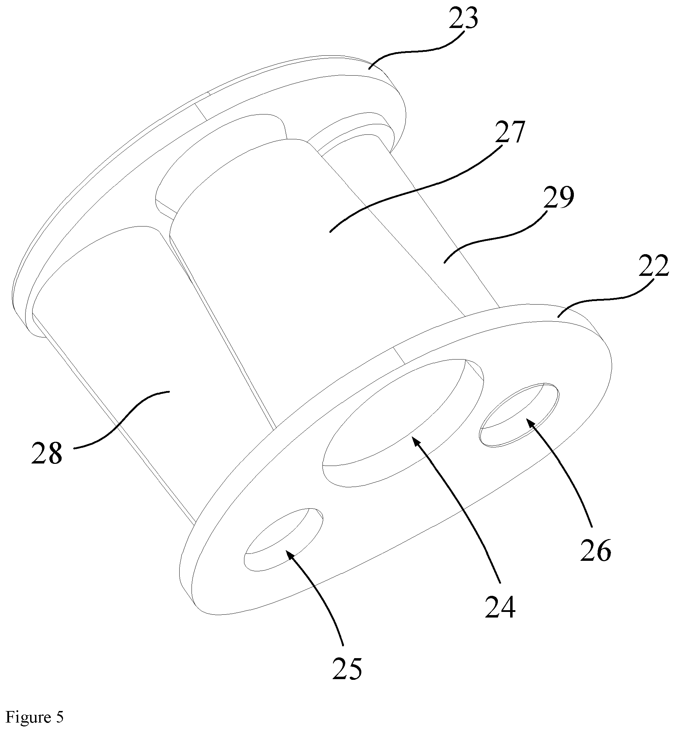

Referring to FIG. 4 and FIG. 5, in an embodiment of the body temperature measuring apparatus 100, the main cover 2 includes an outer shell 21, a first cover plate 22 and a second cover plate 23. The outer shell 21 has a first opening facing the main unit 1 and a second opening deviating from the main unit 1. The first cover plate 22 covers the first opening, and the second cover plate 23 covers the second opening. The first cover plate 22 and the second cover plate 23 are respectively provided with a first avoiding opening 24, the two first avoiding openings 24 are arranged oppositely, a first inner shell 27 is arranged between the first cover plate 22 and the second cover plate 23, the first inner shell 27 is arranged around the first avoiding opening 24, and the first inner shell 27 encloses to form the first channel 30. The ear temperature probe 11 faces the first channel 30 or at least partially extends into the first channel 30. In this embodiment, the first inner shell 27 is arranged between the first cover plate 22 and the second cover plate 23 to enclose the first channel 30. The first channel 30 can guide the emission path of the temperature measurement signal of the ear temperature probe 11, make it point to the target temperature measurement area more concentratedly, and reduce the interference signals from other directions, such as the temperature measurement signal of the forehead temperature probe 12. This arrangement can ensure that the ear temperature probe 11 mainly receives the signal from the target temperature measurement area, thereby improving the reliability of the temperature measurement of the ear temperature probe 11.

Similarly, the first cover plate 22 and the second cover plate 23 are respectively provided with a second avoiding opening 25, the two second avoiding openings 25 are arranged oppositely, a second inner shell 28 is arranged between the first cover plate 22 and the second cover plate 23, the second inner shell 28 is arranged around the second avoiding opening 25, and the second inner shell 28 encloses to form the second channel 31. The forehead temperature probe 12 faces the second channel 31 or at least partially extends into the second channel 31. In this embodiment, the second inner shell 28 is arranged between the first cover plate 22 and the second cover plate 23 to enclose the second channel 31. The second channel 31 can guide the emission path of the temperature measurement signal of the forehead temperature probe 12, make it point to the target temperature measurement area more concentratedly, and reduce the interference signals from other directions, such as the temperature measurement signal of the ear temperature probe 11. This arrangement can ensure that the forehead temperature probe 12 mainly receives the signal from the target temperature measurement area, thereby improving the reliability of the temperature measurement of the forehead temperature probe 12.

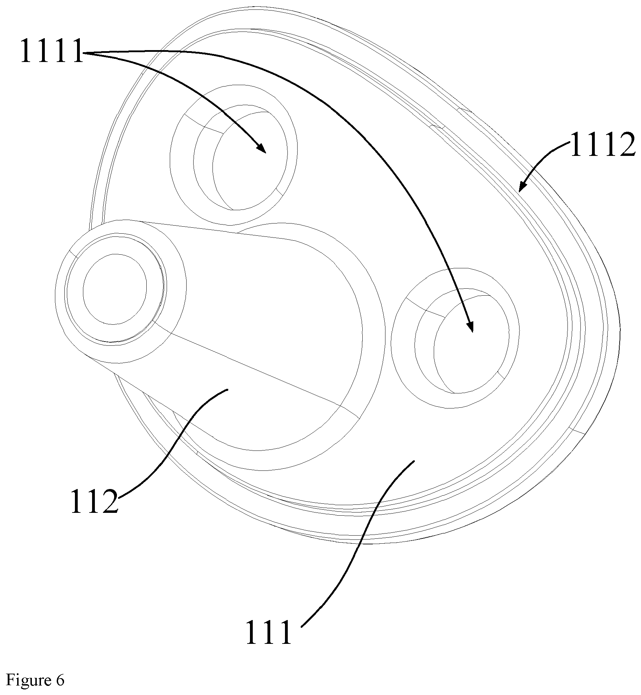

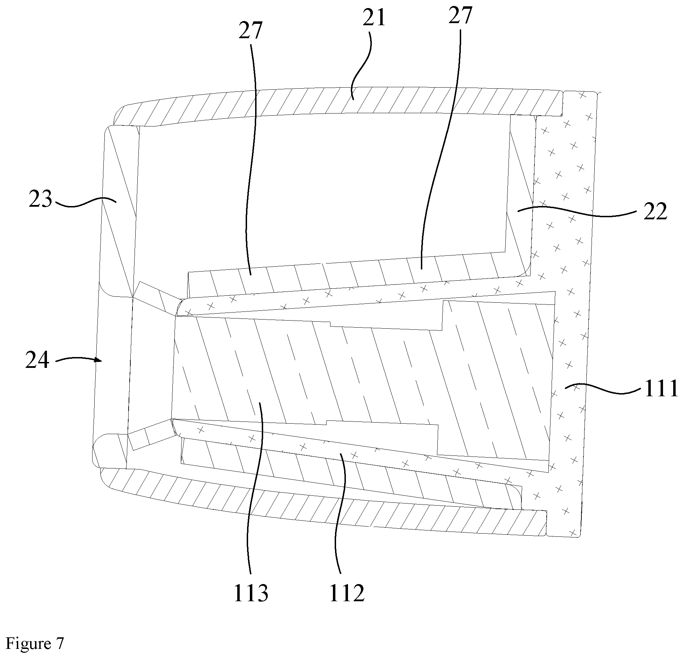

Referring to FIG. 6 and FIG. 7, in an embodiment, the ear temperature probe 11 includes a fixing portion 111, an extending portion 112 and a first temperature sensing element 113. The fixing portion 111 is connected to one end of the main unit 1 facing the main cover 2 and is attached to the first cover plate 22. The extending portion 112 is convexly arranged on the fixing portion 111 and convexly arranged towards one side of the main cover 2. The extending portion 112 is provided with an accommodating cavity extending along the axial direction. One end of the extending portion 112 far away from the fixing portion 111 is provided with an emission port communicated with the accommodating cavity, and the emission port is butted with the first avoiding opening 24 on the second cover plate 23. The first temperature sensing element 113 is arranged in the accommodating cavity.

Wherein, the fixing portion 111 is connected to the shell of the main unit 1 and the first cover plate 22, and the connection mode can be screw connection or buckle connection. The extending portion 112 is convexly arranged on the fixing portion 111 and convexly arranged towards one side of the main cover 2, and is used for inserting into the ear canal, so as to send the first temperature sensing element 113 inside it into the ear canal for temperature measurement. The extending portion 112 can be in a tapered shape along the axial direction, which is convenient for inserting into the ear canal.

The forehead temperature probe 12 includes a second temperature sensing element, which is arranged on one side of the fixing portion 111 facing the main cover 2 and is arranged opposite to the second channel 31. Or the second temperature sensing element is arranged on one side of the fixing portion 111 deviating from the main cover 2 and is arranged opposite to the second channel 31, and the fixing portion 111 is provided with an avoiding hole 1111 arranged opposite to the second temperature sensing element.

Wherein, the control assembly 7 includes a control main board, which is arranged inside the main unit 1. The first temperature sensing element 113 and the second temperature sensing element are respectively electrically connected to the control main board, so that the detected temperature values can be sent to the control main board for fitting calculation.

Referring to FIG. 6, the outer edge of the fixing portion 111 can be provided with a step portion 1112 arranged circumferentially. When the main cover 2 is in the preset state, that is, when the main cover 2 is connected to the main unit 1 and covers the ear temperature probe 11 and the forehead temperature probe 12, the step portion 1112 is in limit fit with the outer shell 21. Specifically, when the main cover 2 is connected to the main unit 1 and covers the ear temperature probe 11 and the forehead temperature probe 12, the bottom wall and the inner wall of the outer shell 21 are respectively in contact with and abutted against the step portion 1112, which can realize the limit between the main cover 2 and the fixing portion 111, and prevent the main cover 2 from being loosened or displaced due to external forces during use.

Further, the body temperature measuring apparatus 100 can include a screen 5, which is arranged on the main unit 1. The control assembly 7 includes a control main board, which is arranged inside the main unit 1. The control main board is electrically connected to the ear temperature probe 11, the forehead temperature probe 12 and the screen 5. The control assembly 7 is used for fitting the temperatures detected by the ear temperature probe 11 and the forehead temperature probe 12, and displaying the fitted temperature on the screen 5.

Specifically, the screen 5 is arranged on the surface of the main unit 1, which is convenient for the user to directly view during operation. The control main board is electrically connected to the ear temperature probe 11, the forehead temperature probe 12 and the screen 5. The control main board is responsible for receiving the temperature data detected by the ear temperature probe 11 and the forehead temperature probe 12, and fitting the data fed back by the two probes through a built-in algorithm, so as to obtain a value more in line with the real human body temperature, and display the fitted temperature on the screen 5. The screen 5 can be a liquid crystal screen 5 (LCD) or an organic light-emitting diode screen 5 (OLED) to ensure that the temperature measurement result is displayed clearly and accurately.

Further, the control assembly 7 also includes a temperature unit switching button 41, which is arranged on the surface of the main unit 1. The control main board is arranged inside the main unit 1, and the control main board is electrically connected to the temperature unit switching button 41 and the screen 5. The control main board receives the signal fed back by the temperature unit switching button 41 to switch the temperature and temperature unit displayed on the screen 5.

The temperature unit switching button 41 can be arranged near the screen 5, which is convenient for the user to quickly switch the temperature unit when viewing the temperature data. The temperature unit switching button 41 allows the user to freely switch between Celsius (°C) and Fahrenheit (°F). The control main board is electrically connected to the temperature unit switching button 41 and the screen 5. When the user presses the temperature unit switching button 41, the control main board receives the signal fed back by the button, converts the temperature unit according to the currently displayed temperature unit, and updates the temperature value and unit mark on the screen 5.

Further, the body temperature measuring apparatus 100 can include a voice player, which is arranged on the main unit 1. The control assembly 7 includes a control main board, which is arranged inside the main unit 1. The control main board is electrically connected to the ear temperature probe 11, the forehead temperature probe 12 and the voice player. The voice player is used for sending out a prompt sound when the temperature measurement of the ear temperature probe 11 and/or the forehead temperature probe 12 is completed.

The voice player is arranged inside the main unit 1 and sends out a prompt sound through a loudspeaker. The position of the loudspeaker should ensure that the sound can be transmitted clearly, and at the same time, avoid interfering with the infrared signal of the temperature measurement probe. The control main board is electrically connected to the ear temperature probe 11, the forehead temperature probe 12 and the voice player. After the temperature measurement is completed, the control main board triggers the voice player to send out a prompt sound. The prompt sound can be a simple "beep", or a voice prompt of "measurement completed", or a direct broadcast of the temperature value. The voice prompt function provides convenience for use in a dark environment and enhances the barrier-free use characteristics of the device.

The control assembly 7 can also include a control button 42, which is arranged on the surface of the main unit 1. The control main board is electrically connected to the control button 42, the screen 5 and/or the voice player. The control main board receives the signal fed back by the control button 42 to switch the working mode of the screen 5 and/or the voice player.

The body temperature measuring apparatus 100 has a normal mode and a night mode (do-not-disturb mode). In the normal mode, the voice player plays a prompt sound at a normal volume, and the screen 5 displays temperature data at a normal brightness; in the night mode (do-not-disturb mode), the voice player is muted, and the screen 5 displays temperature data at a low brightness. The control button 42 is arranged on the surface of the main unit 1, which is convenient for the user to quickly switch between different modes. The control main board is electrically connected to the control button 42, the screen 5 and/or the voice player. The control main board receives the signal fed back by the control button 42 to switch the working mode of the screen 5 and/or the voice player. Through the control button 42, the screen 5 and/or the voice player can be switched between the normal mode and the night mode (do-not-disturb mode), so as to adapt to the use needs of different scenarios and improve the flexibility of the device.

Wherein, the control button 42 and the temperature unit switching button 41 can be physical buttons or touch buttons. The physical buttons have clear tactile feedback, and the touch buttons can be integrated with the screen 5. The touch buttons have high sensitivity, and the user can complete mode switching or temperature unit switching by gently touching the corresponding area on the screen.

Some embodiments of the body temperature measuring apparatus 100 include a distance sensor 13, which is arranged at one end of the main unit 1 facing the main cover 2. The control assembly 7 is electrically connected to the distance sensor 13, and the control assembly 7 controls the distance sensor 13 to be turned on or off according to the signal fed back by the detecting assembly 6.

When the detecting assembly 6 detects that the main cover 2 covers the main unit 1 (forehead temperature measurement mode), the control assembly 7 controls the ear temperature probe 11, the forehead temperature probe 12 and the distance sensor 13 to be in the working state; when the detecting assembly 6 detects that the main cover 2 is separated from the main unit 1, the control assembly 7 controls the ear temperature probe 11 to be in the working state, and controls the forehead temperature probe 12 and the distance sensor 13 to be turned off. The distance sensor 13 is used for detecting whether the ear temperature probe 11 and the forehead temperature probe 12 are in the appropriate temperature measurement position. Specifically, the distance sensor 13 is used for detecting whether the distance between the two probes and the forehead is too far or too close in the forehead temperature measurement mode. If the distance is too far or too close, the control assembly 7 can prompt the user to adjust the position of the probes, so as to ensure the accuracy of the measurement result. When the detecting assembly 6 detects that the main cover 2 is separated from the main unit 1, the control assembly 7 controls the ear temperature probe 11 to be in the working state, and at the same time controls the forehead temperature probe 12 and the distance sensor 13 to be turned off, so as to save energy and avoid unnecessary energy consumption.

In order to avoid the main cover 2 blocking the distance measurement signal of the distance sensor 13 when covering the main unit 1, the main cover 2 is provided with a third channel 32, and the distance sensor 13 faces the third channel 32 or at least partially extends into the third channel 32. The main cover 2 can be provided with a third window, which is arranged opposite to the distance sensor 13, and the coverage area of the third window is the third channel 32. The third window can be a hole structure, or a light-transmitting plate covering the hole structure, such as light-transmitting glass. The third window is used as the signal emission point of the distance sensor 13 to ensure that the distance measurement signal of the distance sensor 13 can be emitted freely.

Alternatively, referring to FIG. 4 and FIG. 5, the first cover plate 22 and the second cover plate 23 are respectively provided with a third avoiding opening 26, the two third avoiding openings 26 are arranged oppositely, a third inner shell 29 is arranged between the first cover plate 22 and the second cover plate 23, the third inner shell 29 is arranged around the third avoiding opening 26, and the third inner shell 29 encloses to form the third channel 32. The distance sensor 13 faces the third channel 32 or at least partially extends into the third channel 32. In this embodiment, the third inner shell 29 is arranged between the first cover plate 22 and the second cover plate 23 to enclose the third channel 32. The third channel 32 can guide the emission path of the distance measurement signal of the distance sensor 13, make it point to the target area more concentratedly, and reduce the interference signals from other directions, such as the temperature measurement signals of the ear temperature probe 11 and the forehead temperature probe 12.

Further, the embodiment of the body temperature measuring apparatus 100 can also include a distance prompting device, which is arranged on the main unit 1 and is electrically connected to the distance sensor 13. The distance prompting device sends out prompting information according to the signal fed back by the distance sensor 13.

The distance prompting device is arranged on the main unit 1 and can be located at the front end or the side of the main unit 1, so that the user can intuitively see the prompting information during operation. The distance prompting device is electrically connected to the distance sensor 13, and the control assembly 7 controls the distance prompting device to send out prompting information according to the signal fed back by the distance sensor 13. For example, the distance prompting device can include a prompt light, which is electrically connected to the distance sensor 13 and is used for turning on when the main unit 1 is in the appropriate position and/or deviates from the appropriate position. For example, the prompt light can include a red light and a green light. The green light is on to indicate that the main unit 1 is in the appropriate temperature measurement position, and the red light is on to indicate that the main unit 1 deviates from the appropriate temperature measurement position. Alternatively, the prompt light can be a flashing light, and the flashing light is on to indicate that the position of the main unit 1 needs to be adjusted.

And/or, the distance prompting device can include a screen 5, which is electrically connected to the distance sensor 13 and is used for displaying the distance detected by the distance sensor 13. The screen 5 can display specific values or prompting information, such as "Distance: 10cm" or "Please approach the target". In practical application, the screen for prompting the distance and the screen for displaying the temperature can be the same screen.

The distance sensor 13 can be an infrared distance sensor 13, an ultrasonic distance sensor 13 or a laser distance sensor 13, etc. The main cover 2 is provided with a third window for distance measurement of the distance sensor 13. The third window is arranged on the main cover 2 at a position corresponding to the distance sensor 13, which ensures that the distance sensor 13 can emit and receive signals without obstruction, thereby accurately detecting the distance between the probe and the target temperature measurement area and avoiding measurement errors caused by the blocking of the main cover 2.

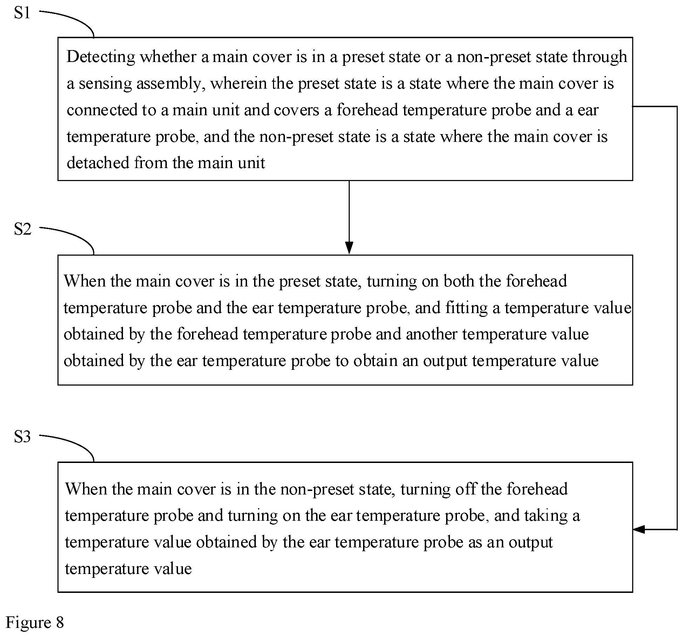

Referring to FIG. 8, the technical solution also provides a control method for a body temperature measuring apparatus, which is used for controlling the above-mentioned body temperature measuring apparatus 100. The control method includes the following steps:
S1: Detecting whether the main cover 2 is in a preset state or a non-preset state through a detecting assembly 6, wherein the preset state is a state where the main cover 2 is connected to the main unit 1 and covers the forehead temperature probe 12 and the ear temperature probe 11, and the non-preset state is a state where the main cover 2 is detached from the main unit 1;
S2: If the main cover 2 is in the preset state, turning on both the forehead temperature probe 12 and the ear temperature probe 11 at the same time, and fitting the temperature value obtained by the forehead temperature probe 12 and the temperature value obtained by the ear temperature probe 11 to obtain an output temperature value;
S3: If the main cover 2 is in the non-preset state, turning off the forehead temperature probe 12, turning on the ear temperature probe 11, and taking the temperature value obtained by the ear temperature probe 11 as the output temperature value.

The body temperature measuring apparatus 100 includes a main unit 1, a main cover 2, a detecting assembly 6 and a control assembly 7. The main unit 1 is provided with a forehead temperature probe 12 and an ear temperature probe 11. The ear temperature probe 11 has an extending portion 112 for inserting into an ear canal. When the main cover 2 is removed, the extending portion 112 of the ear temperature probe 11 can be inserted into the ear canal for ear temperature measurement. The body temperature measuring apparatus 100 has an ear temperature measurement mode and a forehead temperature measurement mode. When the main cover 2 is removed from the main unit 1, that is, when the control assembly 7 detects that the main cover 2 is in the non-preset state, the body temperature measuring apparatus 100 is in the ear temperature measurement mode. At this time, the control assembly 7 turns on the ear temperature probe 11, turns off the forehead temperature probe 12, and only the ear temperature probe 11 is in the working state; when the main cover 2 covers the main unit 1 and covers the ear temperature probe 11 and the forehead temperature probe 12, that is, when the control assembly 7 detects that the main cover 2 is in the preset state, the body temperature measuring apparatus 100 is in the forehead temperature measurement mode. At this time, the control assembly 7 turns on both the ear temperature probe 11 and the forehead temperature probe 12, and both the ear temperature probe 11 and the forehead temperature probe 12 are in the working state, which are jointly used for forehead temperature measurement. In the technical solution, both the ear temperature probe 11 and the forehead temperature probe 12 are arranged on the main unit 1, and the automatic switching of the temperature measurement mode is realized by detecting whether the main cover 2 covers the main unit 1 through the detecting assembly 6. Since the main function of the main cover 2 is to protect the probes and realize the switching of the temperature measurement mode, rather than directly participating in temperature measurement, the disassembly and installation of the main cover 2 will not affect the stability of the electrical connection part of the temperature measurement probes. Even if the connection part of the main cover 2 is slightly worn, it will not affect the temperature measurement function of the temperature measurement probes, thus ensuring the service life of the first temperature measurement probe and the second temperature measurement probe. Moreover, in the technical solution, the disassembly operation of the main cover 2 will not affect the electrical connection between the ear temperature probe 11, the forehead temperature probe 12 and the control assembly 7, which means that in the forehead temperature measurement mode, the ear temperature probe 11 and the forehead temperature probe 12 can measure the temperature at the same time, and the control assembly 7 can obtain the temperature measurement data of the ear temperature probe 11 and the forehead temperature probe 12 at the same time. Since the dual probes can cover more areas, for example, the ear temperature probe 11 may be located at the center of the forehead, and the forehead temperature probe 12 may be located around the center of the forehead, the error caused by the local temperature change of a single measurement point can be reduced. Through the algorithm processing of the control assembly 7, a value more in line with the real human body temperature can be obtained, and the temperature measurement accuracy can be improved.

In some embodiments of the body temperature measuring apparatus 100, one end of the main unit 1 facing the main cover 2 is provided with a distance sensor 13, which is used for detecting whether the distance between itself and the forehead is within a preset distance range in the forehead temperature measurement mode, and further detecting whether the distance between the two probes and the forehead is within the preset distance range. The body temperature measuring apparatus 100 also includes a distance prompting device, which is arranged on the main unit 1 and is electrically connected to the distance sensor 13. The distance prompting device sends out prompting information according to the signal fed back by the distance sensor 13.

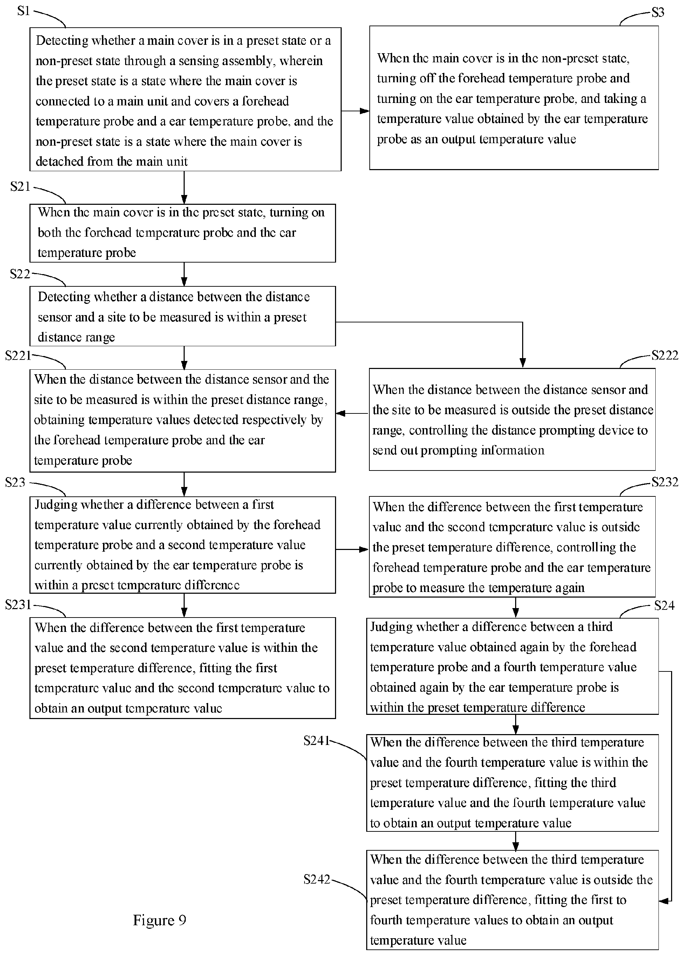

Referring to FIG. 9, if the main cover 2 is in the preset state, after turning on the forehead temperature probe and the ear temperature probe (S21), the method further includes the following steps:
S22: Detecting whether the distance between the distance sensor 13 and the part to be measured is within a preset distance range;
S221: If the distance between the distance sensor 13 and the part to be measured is within the preset distance range, obtaining the temperature values detected by the forehead temperature probe 12 and the ear temperature probe 11, and fitting the temperature value obtained by the forehead temperature probe 12 and the temperature value obtained by the ear temperature probe 11 to obtain an output temperature value;
S222: If the distance between the distance sensor 13 and the part to be measured is outside the preset distance range, controlling the distance prompting device to send out prompting information.

Step S3: If the main cover 2 is in the non-preset state, the method further includes the following steps: controlling the distance sensor and the distance prompting device to be turned off. Specifically, if the main cover 2 is in the non-preset state, that is, when the main cover 2 is removed, the body temperature measuring apparatus is in the ear temperature measurement mode. The control assembly 7 controls the ear temperature probe 11 to be in the working state, and at the same time controls the forehead temperature probe 12, the distance sensor 13 and the distance prompting device to be turned off, so as to save energy and avoid unnecessary energy consumption.

When the main cover is in the preset state, that is, when the main cover is connected to the main unit and covers the forehead temperature probe 12 and the ear temperature probe 11, the body temperature measuring apparatus is in the forehead temperature measurement mode. The control assembly 7 controls the forehead temperature probe 12, the ear temperature probe 11, the distance sensor 13 and the distance prompting device to be in the working state. The distance sensor 13 is used for detecting whether the forehead temperature probe 12 and the ear temperature probe 11 are in the appropriate temperature measurement position. If the distance detected by the distance sensor 13 is within the preset distance range (such as 3cm-5cm), it indicates that the current position is within the appropriate temperature measurement distance; if the distance detected by the distance sensor 13 is outside the preset distance range, it indicates that the current temperature measurement position is too far or too close, and temperature measurement at this distance may lead to measurement errors. Then, the control assembly receives the signal from the distance sensor 13 and controls the distance prompting device to send out prompting information. The prompting information can be an audio prompt, a vibration prompt, or a visual prompt (such as flashing indicator lights), so as to prompt the user to adjust the position of the probe.

When the user adjusts the probe position according to the prompt, so that the distance detected by the distance sensor is within the preset range, the control assembly 7 resets the temperature values of the forehead temperature probe 12 and the ear temperature probe 11 to their initial temperature values, controls the forehead temperature probe 12 and the ear temperature probe 11 to re-measure the temperature, and re-acquires the temperature values detected by the forehead temperature probe 12 and the ear temperature probe 11 at the appropriate position, thereby ensuring the accuracy of the measurement result. When the distance between the distance sensor 13 and the site to be measured is within the preset distance range, the control assembly 7 simultaneously acquires the temperature measurement data of the forehead temperature probe 12 and the ear temperature probe 11. Through algorithm processing by the control assembly 7, the temperature value fed back by the forehead temperature probe 12 and the temperature value fed back by the ear temperature probe 11 are fitted to obtain a final temperature value, which is more consistent with the real human body temperature.

Wherein, if the main unit cover is in the preset state, the control method further includes the following steps:
S23: Judging whether the difference between the first temperature value currently obtained by the forehead temperature probe 12 and the second temperature value currently obtained by the ear temperature probe 11 is within a preset temperature difference;
S231: If the difference between the first temperature value and the second temperature value is within the preset temperature difference, fitting the first temperature value and the second temperature value to obtain an output temperature value;
S232: If the difference between the first temperature value and the second temperature value is outside the preset temperature difference, controlling the forehead temperature probe 12 and the ear temperature probe 11 to re-measure the temperature.

Wherein, the first temperature value and the second temperature value can be fitted according to the following formula:
$T = \frac{T 1 + T 2}{2}$

Wherein, T1 is the first temperature value currently detected by the forehead temperature probe 12, and T2 is the second temperature value currently detected by the ear temperature probe 11. That is, the built-in algorithm of the control assembly 7 can average the temperature values detected by the forehead temperature probe 12 and the ear temperature probe 11. At this time, if the first temperature value T1 detected by the forehead temperature probe 12 and the second temperature value T2 detected by the ear temperature probe 11 are less than or equal to the preset temperature difference e.g., within a difference of 0.3°C, it means that the temperature values detected by the two probes are relatively close, and the measurement results of the two probes can be considered reliable. The average of these two temperature values can be calculated as the output temperature value. The average calculation method can comprehensively consider the measurement results of the forehead temperature probe 12 and the ear temperature probe 11, reduce errors caused by local temperature changes at a single measurement point, and thus obtain a value more consistent with the real human body temperature.

If the first temperature value T1 and the second temperature value T2 are outside the preset temperature difference, it is considered that the two probes may be affected by factors such as sweat and environmental temperature changes, resulting in large differences in measurement results. In this case, the control assembly 7 will control the forehead temperature probe 12 and the ear temperature probe 11 to re-measure the temperature.

Continuing to refer to FIG. 9, the specific steps after re-measuring the temperature after step S232 can be as follows:
S24: Judging whether the difference between the third temperature value obtained again by the forehead temperature probe 12 and the fourth temperature value obtained again by the ear temperature probe 11 is within the preset temperature difference;
S241: If the difference between the third temperature value and the fourth temperature value is within the preset temperature difference, fitting the third temperature value and the fourth temperature value to obtain an output temperature value;
S242: If the difference between the third temperature value and the fourth temperature value is outside the preset temperature difference, fitting the first temperature value, the second temperature value, the third temperature value, and the fourth temperature value to obtain an output temperature value.

Wherein, the third temperature value and the fourth temperature value can be fitted according to the following formula:
$T = \frac{T 3 + T 4}{2}$

Wherein, T is the output temperature value, T3 is the third temperature value, which is the temperature value re-measured by the forehead temperature probe 12, and T4 is the fourth temperature value, which is the temperature value re-measured by the ear temperature probe 11. After the two probes re-measure the temperature, the control assembly 7 recalculates the absolute value of the difference between T3 and T4, i.e., |T3 - T4|. If |T3 - T4| is less than or equal to the preset temperature difference e.g., 0.3°C, it can be considered that the current temperature measurement is less affected by factors such as the user's sweat and environmental temperature changes, the current temperature measurement is relatively reliable, and the average of T3 and T4 can be taken as the output temperature value.

If after re-measuring the temperature, the temperature difference between the two probes is still outside the preset temperature difference, i.e., |T3 - T4| is still greater than the preset temperature difference, it indicates that there is still a large difference between the re-measurement results of the two probes, and influencing factors such as sweat and environmental temperature changes are difficult to avoid. At this time, the control assembly 7 will include all the temperature values from the first and second temperature measurements in the fitting formula to improve the accuracy and reliability of the measurement result.

At this time, the first temperature value, the second temperature value, the third temperature value, and the fourth temperature value can be fitted according to the following formula:
$T = \frac{T 1 + T 2 + T 3 + T 4}{4}$

Wherein, T is the output temperature value, T1 is the first temperature value, T2 is the second temperature value, T3 is the third temperature value, and T4 is the fourth temperature value. This fitting method is average fitting, which can avoid the influence of abnormal values from a certain measurement on the final result.

Alternatively, the first temperature value, the second temperature value, the third temperature value, and the fourth temperature value can be fitted according to the following formula:
$T = \frac{w 1 \cdot \left(\frac{T 1 + T 3}{2}\right) + w 2 \cdot \left(\frac{T 2 + T 4}{2}\right)}{w 1 + w 2}$

Wherein, T is the output temperature value, T1 is the first temperature value, T2 is the second temperature value, T3 is the third temperature value, T4 is the fourth temperature value, w1 is the weight of the average value of the first temperature value and the third temperature value, w2 is the weight of the average value of the second temperature value and the fourth temperature value. If |T1 - T3| = |T2 - T4|, then w1 = w2; if |T1 - T3| < |T2 - T4|, then w1 > w2; if |T1 - T3| > |T2 - T4|, then w1 < w2.

It should be noted that if |T1 - T3| < |T2 - T4|, it is considered that the temperature difference between the two measurements of the forehead temperature probe 12 is smaller than that of the ear temperature probe 11, and the measurement result of the forehead temperature probe 12 is considered more stable, thus assigning a larger weight to the average value of the two measurements of the forehead temperature probe 12, i.e., w1 > w2.

If |T1 - T3| > |T2 - T4|, it is considered that the temperature difference between the two measurements of the ear temperature probe 11 is smaller than that of the forehead temperature probe 12, and the measurement result of the ear temperature probe 11 is considered more stable, thus assigning a larger weight to the average value of the two measurements of the ear temperature probe 11, i.e., w1 < w2.

If |T1 - T3| = |T2 - T4|, it is considered that the temperature difference between the two measurements of the forehead temperature probe 12 is equivalent to that of the ear temperature probe 11, and the same weight can be assigned to the average values of the two measurements of the forehead temperature probe and the ear temperature probe, i.e., w1 = w2.

This weighted average calculation method can comprehensively consider the stability of the two measurements, assign a larger weight to more stable measurement results, and thus obtain a value more consistent with the real human body temperature. Under complex conditions such as the user having sweat or environmental temperature changes, the stability of the measurement result can be improved through multiple temperature measurements and comprehensive fitting.

The following is an example with a preset temperature difference of 0.3°C.

If during the first temperature measurement, the temperature value obtained by the forehead temperature probe 12 is 37.5°C, and the temperature value obtained by the ear temperature probe 11 is 37.8°C, the temperature difference between them is 0.3°C, which is within the allowable difference range. The average of 37.5°C and 37.8°C, which is 37.65°C (37.7°C when rounded), is taken as the output temperature value.

If during the first temperature measurement, the temperature value obtained by the forehead temperature probe 12 is 37.5°C, and the temperature value obtained by the ear temperature probe 11 is 38°C, the temperature difference between them is 0.5°C, which exceeds the preset temperature difference of 0.3°C, so re-measurement is required.

Assuming that during the second temperature measurement, the temperature value obtained by the forehead temperature probe 12 is 37.6°C, and the temperature value obtained by the ear temperature probe 11 is 37.9°C, the temperature difference between them is 0.3°C, which is within the allowable difference range. The average of 37.6°C and 37.9°C, which is 37.75°C (37.8°C when rounded), is taken as the output temperature value.

Assuming that during the second temperature measurement, the temperature value obtained by the forehead temperature probe 12 is 37.7°C, and the temperature value obtained by the ear temperature probe 11 is 38.1°C, the temperature difference between them is 0.4°C, which still exceeds the preset temperature difference of 0.3°C. All temperature values from the first and second temperature measurements need to be included in the fitting formula.

For example, all temperature values from the first and second temperature measurements can be included in the simple average fitting formula T = T1 + T2 + T3 + T4 / 4, and 37.825°C (37.8°C when rounded) is taken as the output temperature value.

Alternatively, a weighted average can be used for fitting, specifically as follows: |37.5 - 37.7| = 0.2°C, |38 - 38.1| = 0.1°C. Since |T1 - T3| > |T2 - T4|, a larger weight is assigned to the average value of the two measurements of the ear temperature probe 11, i.e., w1 < w2.

Assuming w2 = 02 and w1 = 01, then *T* = *(* (37.5 + 37.7) /2 × 1*)* + *( (*38 + 38.1) /2 × 2*)* / (2 + 1*)* = 37.9, and 37.9°C is taken as the output temperature value.

In conclusion, the control method uses the measurement results from two successive measurements for fitting calculation, which can reduce measurement errors caused by environmental factors such as environmental temperature changes, user's sweat, etc., perform a certain degree of environmental compensation, and thus improve the accuracy and reliability of the measurement.

The above descriptions are only preferred embodiments of the present disclosure and are not intended to limit the present disclosure. Any modification, equivalent replacement, improvement, etc., made within the spirit and principle of the present disclosure shall be included in the protection scope of the present disclosure.

## Claims

1. A body temperature measuring apparatus, comprising:
a main unit (1), comprising a forehead temperature probe (12) and an ear temperature probe (11), and the ear temperature probe (11) comprising an extending portion (112) for inserting into an ear canal;
a main cover (2), provided with a preset state where the main cover (2) is connected to the main unit (1) and covers the forehead temperature probe (12) and the ear temperature probe (11), and a non-preset state where the main cover (2) is detached from the main unit (1), wherein the main cover (2) defines a first channel (30) and a second channel (31) for temperature measurement signals to pass through, the forehead temperature probe (12) faces the first channel (30) or partially extends into the first channel (30) in the preset state, and the extending portion (112) partially extends into the second channel (31) in the preset state;
a detecting assembly (6), arranged on the main unit (1) and/or the main cover (2)coupling position, and used for detecting whether the main cover (2) is in the preset state;
a control assembly (7), electrically connected to the detecting assembly (6), the forehead temperature probe (12), and the ear temperature probe (11), wherein the control assembly (7) obtains whether the main cover (2) is in the preset state through the detecting assembly (6), and selects to turn on both the forehead temperature probe (12) and the ear temperature probe (11) or only turn on the ear temperature probe (11).

2. The body temperature measuring apparatus according to claim 1, wherein the detecting assembly (6) is arranged at a coupling position of the main unit (1) and the main cover (2).

3. The body temperature measuring apparatus according to claim 2, wherein the detecting assembly (6) comprises a magnetic member and a Hall sensing element that generates a magnetic induction signal when the magnetic member is close, the Hall sensing element is arranged at the coupling position of the main unit (1) that couples with the main cover (2), the magnetic member is arranged at the coupling position of the main cover (2) that couples with the main unit (1), the control assembly (7) is electrically connected to the Hall sensing element, and the control assembly (7) selects to turn on both the forehead temperature probe (12) and the ear temperature probe (11) or only turn on the ear temperature probe (11) according to whether the Hall sensing element generates the magnetic induction signal; and/or
the detecting assembly (6) comprises a pressure sensor triggered by the main cover (2) in the preset state, the pressure sensor is arranged at the coupling position of the main unit (1) that couples with the main cover (2), the control assembly (7) is electrically connected to the pressure sensor, and the control assembly (7) selects to turn on both the forehead temperature probe (12) and the ear temperature probe (11) or only turn on the ear temperature probe (11) according to whether the pressure sensor senses a pressure signal.

4. The body temperature measuring apparatus according to claim 1, wherein the main cover (2) comprises an outer shell (21), a first cover plate (22), a second cover plate (23), a first inner shell (27), and a second inner shell (28), the outer shell (21) comprises a first opening facing the main unit (1) and a second opening deviating from the main unit (1), the first cover plate (22) covers the first opening, and the second cover plate (23) covers the second opening;
the first cover plate (22) and the second cover plate (23) respectively define a first avoiding opening (24), the two first avoiding openings (24) are arranged oppositely; the first inner shell (27) is arranged between the first cover plate (22) and the second cover plate (23) to surround the two first avoiding openings (24); the first inner shell (27) defines the first channel (30);
the first cover plate (22) and the second cover plate (23) respectively define a second avoiding opening (25), the two second avoiding openings (25) are arranged oppositely, the second inner shell (28) is arranged between the first cover plate (22) and the second cover plate (23) to surround the two second avoiding opening (25), the second inner shell (28) defines the second channel (31).

5. The body temperature measuring apparatus according to claim 1, wherein the ear temperature probe (11) further comprises a fixing portion (111) and a first temperature sensing element (113), the fixing portion (111) is connected to an end of the main unit (1) facing the main cover (2), the extending portion (112) protrudes from the fixing portion (111) towards the main cover (2), the extending portion (112) defines an accommodating cavity extending along an axial direction thereof, one end of the extending portion (112) far away from the fixing portion (111) is provided with an emission port communicated with the accommodating cavity, and the first temperature sensing element (113) is arranged in the accommodating cavity;
the forehead temperature probe (12) comprises a second temperature sensing element, the second temperature sensing element is arranged on a side of the fixing portion (111) facing the main cover (2) and is arranged corresponding to the second channel (31); or the second temperature sensing element is arranged on a side of the fixing portion (111) deviating from the main cover (2) and is arranged corresponding to the second channel (31), and the fixing portion (111) defines an avoiding hole (1111) arranged corresponding to the second temperature sensing element.

6. The body temperature measuring apparatus according to claim 1, wherein the body temperature measuring apparatus further comprises a distance sensor (13) arranged at an end of the main unit (1) facing the main cover (2), the control assembly (7) is electrically connected to the distance sensor (13) and controls the distance sensor (13) to be turned on or off according to the signal fed back by the detecting assembly (6);
the main cover (2) defines a third channel (32), and the distance sensor (13) faces the third channel (32) or at least partially extends into the third channel (32).

7. The body temperature measuring apparatus according to claim 6, wherein the main cover (2) comprises an outer shell (21), a first cover plate (22), a second cover plate (23), and a third inner shell (29), the outer shell (21) comprises a first opening facing the main unit (1) and a second opening deviating from the main unit (1), the first cover plate (22) covers the first opening, and the second cover plate (23) covers the second opening;
the first cover plate (22) and the second cover plate (23) respectively define a third avoiding opening (26), the two third avoiding openings (26) are arranged oppositely, the third inner shell (29) is arranged between the first cover plate (22) and the second cover plate (23) to surround the third avoiding opening (26), and the third inner shell (29) defines the third channel (32).

8. A control method for controlling the body temperature measuring apparatus in claim 1, comprising:
detecting whether a main cover (2) is in a preset state or a non-preset state through a detecting assembly (6), wherein the preset state is a state where the main cover (2) is connected to a main unit (1) and covers a forehead temperature probe (12) and an ear temperature probe (11), and the non-preset state is a state where the main cover (2) is detached from the main unit (1);
when the main cover (2) is in the preset state, turning on both the forehead temperature probe (12) and the ear temperature probe (11), and fitting a temperature value obtained by the forehead temperature probe (12) and another temperature value obtained by the ear temperature probe (11) to obtain an output temperature value;
when the main cover (2) is in the non-preset state, turning off the forehead temperature probe (12) and turning on the ear temperature probe (11), and taking a temperature value obtained by the ear temperature probe (11) as an output temperature value.

9. The control method according to claim 8, wherein the body temperature measuring apparatus comprises a distance sensor (13) and a distance prompting device, the distance sensor (13) is arranged at an end of the main unit (1) facing the main cover (2), and the distance prompting device is arranged on the main unit (1) and is electrically connected to the distance sensor (13);
when the main cover (2) is in the preset state, after turning on both the forehead temperature probe (12) and the ear temperature probe (11), the method further comprises;
detecting whether a distance between the distance sensor (13) and a site to be measured is within a preset distance range;
when the distance between the distance sensor (13) and the site to be measured is within the preset distance range, obtaining temperature values detected respectively by the forehead temperature probe (12) and the ear temperature probe (11), and fitting a temperature value obtained by the forehead temperature probe (12) and another temperature value obtained by the ear temperature probe (11) to obtain an output temperature value;
when the distance between the distance sensor (13) and the site to be measured is outside the preset distance range, controlling the distance prompting device to send out prompting information; when the main cover (2) is in the non-preset state, turning of the distance sensor (13) and the distance prompting device.

10. The control method according to claim 8, wherein when the main cover (2) is in the preset state, the method further comprises the following steps:
judging whether a difference between a first temperature value currently obtained by the forehead temperature probe (12) and a second temperature value currently obtained by the ear temperature probe (11) is within a preset temperature difference;
when the difference between the first temperature value and the second temperature value is within the preset temperature difference, fitting the first temperature value and the second temperature value to obtain an output temperature value;
when the difference between the first temperature value and the second temperature value is outside the preset temperature difference, controlling the forehead temperature probe (12) and the ear temperature probe (11) to measure the temperature again.

11. The control method according to claim 10, wherein when the difference between the first temperature value and the second temperature value is within the preset temperature difference, a formula for fitting the first temperature value and the second temperature value is *T =* (*T*1 *+ T*2) / 2, where T is the output temperature value, T1 is the first temperature value, and T2 is the second temperature value.

12. The control method according to claim 10, wherein after controlling the forehead temperature probe (12) and the ear temperature probe (11) to measure the temperature again, the method further comprises the following steps:
judging whether a difference between a third temperature value obtained again by the forehead temperature probe (12) and a fourth temperature value obtained again by the ear temperature probe (11) is within the preset temperature difference;
when the difference between the third temperature value and the fourth temperature value is within the preset temperature difference, fitting the third temperature value and the fourth temperature value to obtain an output temperature value;
when the difference between the third temperature value and the fourth temperature value is outside the preset temperature difference, fitting the first to fourth temperature values to obtain an output temperature value.

13. The control method according to claim 12, wherein when the difference between the third temperature value and the fourth temperature value is within the preset temperature difference, a formula for fitting the third temperature value and the fourth temperature value is *T* = (*T*3 + *T*4) / 2, where T is the output temperature value, T3 is the third temperature value, and T4 is the fourth temperature value.

14. The control method according to claim 12, wherein when the difference between the third temperature value and the fourth temperature value is outside the preset temperature difference, a formula for fitting the first to fourth temperature values is *T* = (*T*1 + *T*2 + *T*3 + *T*4) / 4*,* where T is the output temperature value, T1 is the first temperature value, T2 is the second temperature value, T3 is the third temperature value, and T4 is the fourth temperature value; or
a formula for fitting the first to fourth temperature values is *T* = ((*w*1 • (*T*1 + *T*3) / 2) + (*w*2 • (*T*2 *+ T*4) / *2))*/(*w*1 + *w*2), where T is the output temperature value, T1 is the first temperature value, T2 is the second temperature value, T3 is the third temperature value, T4 is the fourth temperature value, *w*1 is a weight of the average value of the first temperature value and the third temperature value, *w*2 is a weight of the average value of the second temperature value and the fourth temperature value; when |*T*1-*T*3| *=* |*T*2 - *T*4|, then *w*1 = *w*2, when |*T*1-*T*3|<|*T*2*-T*4|, then *w*1 > *w*2, when |*T*1-*T*3*>*|*T*2*-T*2|, then *w*1 < *w*2.
